# EUROPEAN PATENT APPLICATION

(11) **EP 1 632 952 A2**
(43) Date of publication of application: **08.03.2006**
(21) Application number: 05254988.8
(22) Date of filing: 11.08.2005
(51) Int. Cl.: G11C 16/20

(54) **A non-volatile memory device controlled by a micro-controller**

(30) Priority: 16.08.2004 US 918509
(71) Applicant: Saifun Semiconductors Ltd., 42505 Netanya (IL)
(72) Inventor: Edan, Mori, Carmel 30855 (IL); Sofer, Yair, Tel aviv 62265 (IL); Grossgold, Meir, Ra'anana 43556 (IL); Eliyahu, Ron, Herzelia (IL)
(74) Representative: Holmes, Matthew Peter

(57) **Abstract**

A system and a method for operating a non-volatile memory (NVM) device including a micro-controller adapted to control peripheral circuitry associated with an NVM array. The method includes providing at least one operation command to the micro-controller of the NVM device and applying operating signals to peripheral circuitry of the NVM device to operate the NVM array based on at least one operation command. The system includes: a NVM device (20) with a NVM array (28) adapted to store data and commands, peripheral circuitry (P₁...Pₙ) adapted to operate the NVM array and a micro-controller (24) adapted to control the peripheral circuitry; and an external device to provide at least one command to the micro-controller of the NVM device.

## Description

### FIELD OF THE INVENTION

The present invention relates generally to non-volatile memory devices, and particularly to improved manufacturing and development of such memory devices.

### BACKGROUND OF THE INVENTION

The manufacturing and development process of a new generation of an integrated circuit (IC) may typically last 18 to 21 months. The process may typically consist of more than a hundred steps, during which hundreds of copies of IC's are formed on a single wafer. The process may typically begin with design steps such as system, logic, circuit, and polygons design. Generally, the design steps may last 12 months and may result in a tape-out of the designed IC. Consequently, the tape-out may be shipped to fabrication and may typically be the basis of the manufacturing of the IC. The manufacturing of the IC may last 6-9 months and may include front-end and back-end stages. The front-end stage may typically include wafer fabrication steps, and may last 3 months, while the back-end stage that may typically include package assembly and various tests, such as burn-in and environmental tests, electrical tests and tests of production, may typically last 3-6 months.

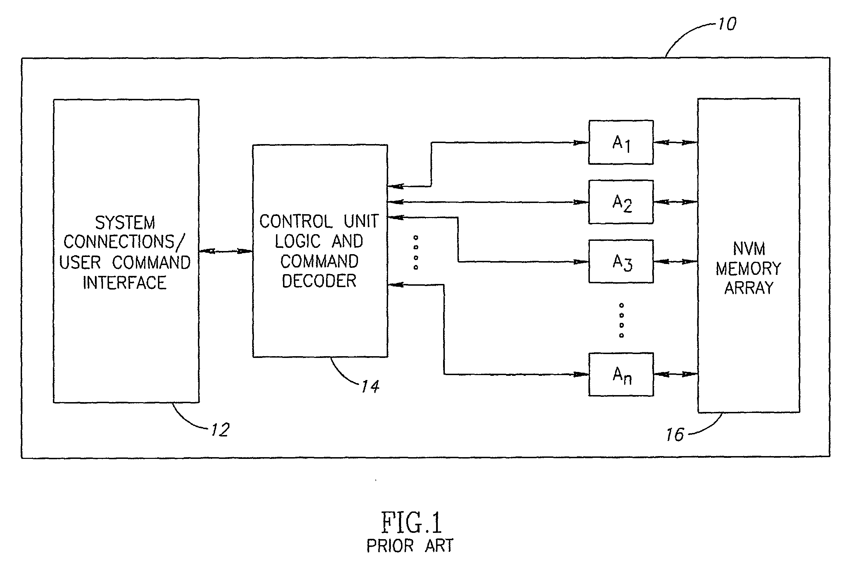

Reference is made to Fig. 1 which is a simplified block diagram of a typical IC device. Generally, the IC device 10 may include system connections/user command interface 12, a control logic unit and command decoder 14, periphery blocks A₁ through Aₙ, and a main non-volatile memory (NVM) array 16

Typically, user commands such as program and erase may be introduced to IC device 10 through the system connections/user command interface 12 and may be executed as embedded operations. Usually, control logic unit and command decoder 14 may control the embedded operations. The embedded operations, e.g., program, erase, and read commands, may typically be pre-defined, and may combine electrical pulses and verify operations. The electrical pulses may change the data stored in the main NVM array 16, in accordance with the user commands and data, and the verify operations may control the progress of the execution of the commands.

Control logic unit and command decoder 14 may typically be a synchronous logic design block. It may control the periphery blocks A₁ through An which may be essential to execute the embedded operations. Periphery blocks A₁ through An may include, for example, internal power supply circuits of lC device 10, rows and columns decoders, data buffers, and other internal circuits that may be required for the operation of IC device 10.

Typically, control logic unit and command decoder 14 may be built of state machines, counters and registers. Therefore, a change in the definition of an embedded operation, e.g., in the program process, or in the erase process, may require a change in the layout design of IC device 10.

An additional change in the memory chip that may lead to a change in the design of the chip may be a change in the definition of one of the periphery blocks A₁ through Aₙ.

Generally, changes in the definition of the embedded operations or a change in the periphery blocks A₁ through Aₙ may significantly effect the development and the manufacturing process of lC device 10. The later the required change appears in the design process, the more severe its effect on the development and manufacturing process, mainly because the definitions of the embedded operations and the periphery blocks are typically determined during the design steps. Therefore, when the change appears after tape-out, a full new tape-out may be required resulting in loss of time and resources.

### SUMMARY OF THE INVENTION

There is provided in accordance with embodiments of the present invention a non-volatile memory (NVM) device comprising a micro-controller adapted to control peripheral circuitry associated with an NVM array.

There is further provided in accordance with embodiments of the present invention a system comprising a NVM device including a NVM array adapted to store data and commands, peripheral circuitry adapted to operate said NVM array and a micro-controller adapted to control the peripheral circuitry; and an external device to provide at least one command to the micro-controller of the NVM device.

There is further provided in accordance with embodiments of the present invention a method for operating a non-volatile memory (NVM) device, comprising providing at least one operation command to a micro-controller of the NVM device; and applying operating signals to peripheral circuitry of the NVM device to operate a NVM array based on at least one operation command.

### BRIEF DESCRIPTION OF THE DRAWINGS

The subject matter regarded as the invention is particularly pointed out and distinctly claimed in the concluding portion of the specification. The invention, however, both as to organization and method of operation, together with objects, features and advantages thereof, may best be understood by reference to the following non limiting detailed description when read with the accompanied drawings in which:

Fig. 1 is a simplified block diagram of a typical IC device;

Fig. 2 is a simplified block diagram of a non-volatile memory (NVM) device controlled by a micro-controller in accordance with an embodiment of the present invention;

Fig. 3 is a simplified block diagram of a basic interface of command decoder (CMD), in accordance with an embodiment of the present invention;

Fig. 4 is a flow chart illustration of an execution of a command which is controlled by a micro-controller in accordance with some embodiments of the present invention;

Fig. 5 is a simplified block diagram of a command synchronization block, in accordance with an embodiment of the present invention;

Fig. 6 is a flow chart illustration of execution of commands when the micro-controller is executing a different command in accordance with an embodiment of the present invention; and

Fig. 7 is a simplified graph of a simulation of various signals involved in a data out operation of one of the periphery blocks, in accordance with an embodiment of the present invention.

It will be appreciated that for simplicity and clarity of these nonlimiting illustrations, elements shown in the figures have not necessarily been drawn to scale. For example, the dimensions of some of the elements may be exaggerated relative to other elements for clarity. Further, where considered appropriate, reference numerals may be repeated among the figures to indicate corresponding or analogous elements.

### DETAILED DESCRIPTION OF THE PRESENT INVENTION

In accordance with embodiments of the present invention, implementation of a micro-controller in or associated with a NVM device may improve the development and the manufacturing process of the memory device.. In embodiments of the invention, when changes are required during the development and manufacturing of the NVM device, such as changes to the operating procedure of the NVM, including user commands such as program and erase, the micro-controller may receive the new user commands from the micro-controller, for example, via a user command interface. The NVM device may then be operated according to such new commands with substantially little delay in development and manufacturing processes. In some embodiments of the invention, user commands may be changed and inserted to the NVM device when the memory device is already in production, substantially without effecting the production process.

The use of a micro-controller in NVM device in accordance with embodiments of the present invention may also enhance the process of enabling the device, e.g., the power-up process, when the memory device is not programmable and operable and the device is in the development or manufacturing stages. Some embodiments of a micro-controller in accordance with the present invention may also enhance other operations of the NVM device, such as command insertion to the memory device, or self-testing of the NVM device.

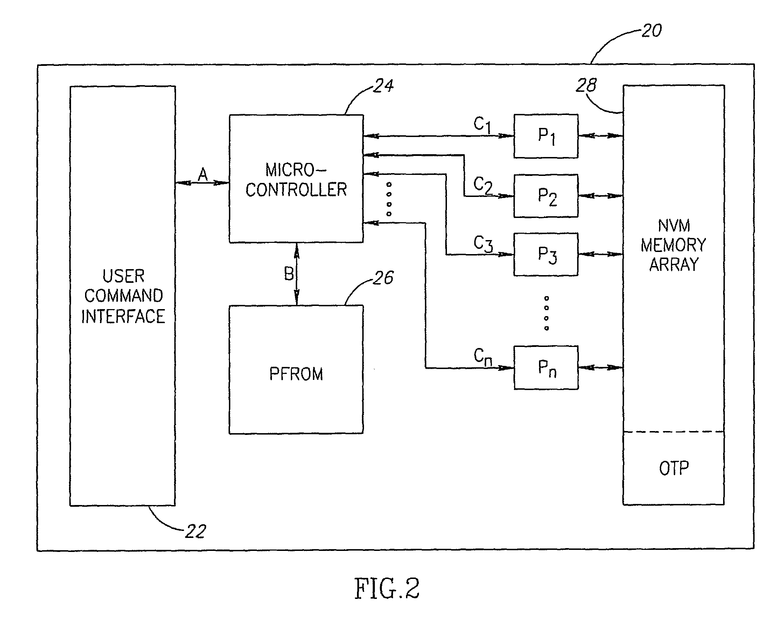

Reference is now made to Fig. 2, which is a simplified block diagram of a non-volatile memory (NVM) device 20 controlled by a micro-controller 24 in accordance with an embodiment of the present invention. NVM device 20 may include, for example, a user command interface 22, a micro-controller 24, a program file ROM (PFROM) 26, periphery blocks P₁ through Pₙ, and an NVM array 28.

NVM device 20 may communicate with an external device, such as, for example, a PDA, a handheld device, a programmable logic device (PLD), a memory card, a multimedia card etc., through user command interface 22. User command interface 22 may transfer and receive commands and data signals to and from micro-controller 24 through communication bus A. Micro-controller 24 may control the operation of NVM device 20, e.g., it may receive command sequences and data signals from user command interface 22, decode the command sequences, and transfer the decoded commands to periphery blocks P₁ to Pₙ and thence to the NVM 20.

Micro-controller 24 may communicate with PFROM 26 and periphery blocks P₁ to Pₙ through communication buses B, and C₁-Cₙ, respectively. Communication bus B may be used, for example, to transfer a command sequence or an instruction code from PFROM 26 to micro-controller 24. In some embodiments of the invention, communication bus B may serve as the communication line to the program counter of the micro-controller 24. The program counter (PC) of the micro-controller may be associated with a portion of PFROM 26. A program counter (PC) may typically be a register that holds the location or address of the next command or instruction to be executed. The PC is typically incremented after each instruction is fetched. For enhanced performance of NVM device 20, a second communication bus (not shown) from PFROM 26 to micro-controller 24 may be used as a dedicated PC line of the micro-controller 24.

Communication buses C₁-Cₙ may enable micro-controller 24 to communicate with the periphery blocks P₁ to Pₙ to operate the embedded operation. The periphery blocks P₁ to Pₙ may include, for example, internal power supply circuits of NVM device 20, row and column decoders, data buffers, and other internal circuits that may be required for the operation of NVM device 20.

NVM device 20 may include a program file ROM (PFROM) 26. PFROM 26 may be an NVM array, such as, for example, the NVM array described in U.S. Patent Number 5,963,465, assigned to the same assignee as the present application, and may be operable in a method such as, for example, the method described in U.S. Patent Application Ser. No. 10/826,375, filed on April 19, 2004, and, assigned to the same assignee as the present application, which both applications are incorporated herein by reference in their entireties.

PFROM 26 may, for example, store the main program and erase flows. It may be programmed to store the main program and erase flows during the different phases of the development and the manufacturing of the memory device. For example, PFROM 26 may be programmed to store the main program and erase flows during the phase of checking and examining the memory device, e.g., the SORT phase. The SORT phase may typically include basic checks and examinations, such as but not limited to internal supply verification, defect detection of the memory array cells, defect detection of the memory array reference cells, examination of the program and erase flows etc. Typically, the SORT phase may be performed as part of the back-end stages of the manufacturing of integrated circuits.

In accordance with an embodiment of the present invention, NVM device 20 may be operated when PFROM 26 is not programmed, e.g., before the SORT phase, to enable various operations, such as, for example, read operation of voltages in the NVM device 20, and initial program operations of PFROM 26. The software that may be programmed and stored on PFROM 26 may include, for example, a process for a complete power-up process of NVM device 20. After PFROM 26 is programmed, the power-up process may be used every time that NVM device 20 may be turned on.

In accordance with an embodiment of the invention, the power-up process may be adapted to configure parameters for certain operations of NVM 20. The power-up process may be used, for example, to configure parameters necessary for read operations. These parameters may include, for example, trimming options of the internal voltages within NVM device 20, timing elements delay like the sensing time of the array data, and/or other parameters.

In accordance with an embodiment of the present invention, the power-up process may be adapted to configure parameters for internal algorithms that may be used by NVM device 20 in erase operation. For example, the erase pulse width may be a parameter that effects the program and erase algorithms. Micro-controller 24 may download this parameter, or other internal parameters during the power-up process, and store such parameters in a programmable section of NVM array 28. According to an exemplary embodiment of the invention, this programmable section of NVM array 28 may be one-time programmable (OTP). Part of such an OTP section in NVM array 28 may be accessed by an external device such as, for example, a PDA, a handheld device, a programmable logic device (PLD), a memory card, a multimedia card etc. In addition or in the alternative, part of the programmable section may be accessed by micro-controller 24 for internal use. For example, the internal parameters that may be stored in the programmable section during the power-up process may be the parameters that may be used during the execution of the internal algorithms.

In accordance with some embodiments of the present invention the OTP section of NVM memory array 28 may be used to store, for example, redundancy data. The redundancy data may be data that maps dedicated memory areas in NVM memory array 28 that may not be used during the operation of the NVM device 20. The redundancy data may be used, for example, in cases that memory areas in NVM memory array 28 are defected, for example, during the production of NVM memory array 28. During the power-up process, the redundancy data may be downloaded from the OTP to the micro-controller 24 that may control the replacement of the defected memory areas of NVM memory array 28 with the dedicated unused memory area throughout the operation of NVM device 20.

An additional process that may be performed, for example, during the power-up process, in accordance with an exemplary embodiment of the present invention, may be the validation of the voltage supply to NVM device 20. When the voltage of NVM device 20 is below a predetermined threshold level, the power-up process may be halted until the voltage may reach the predetermined threshold level. The predetermined threshold voltage level may be stored, for example, in the OTP section of NVM memory array 28, and during the power-up process micro-controller 24 may retrieve the threshold voltage level and compare it with the actual voltage level of NVM device 20. In accordance with a second exemplary embodiment of the present invention the predetermined threshold voltage level may be stored, for example, in PFROM 26, and the micro-controller 24 may retrieve it from there.

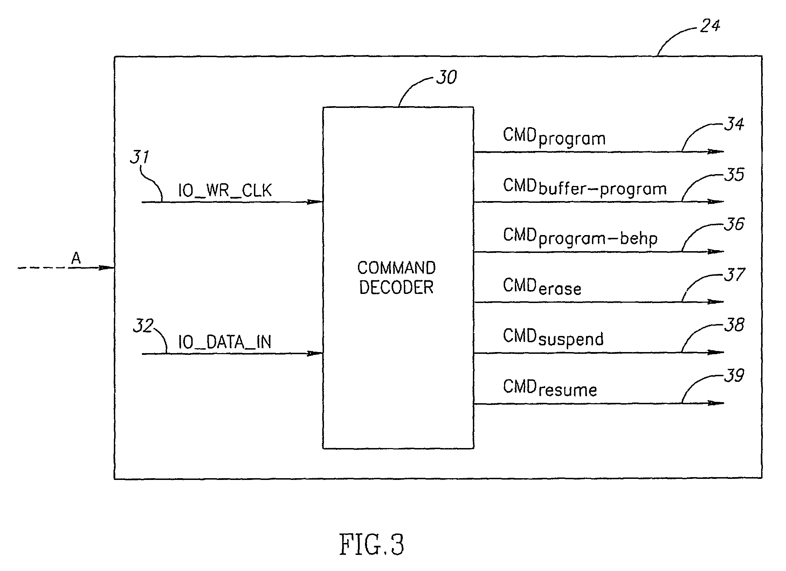

Making reference to Fig. 3, which is a simplified block diagram of an interface unit. In the embodiment depicted, micro-controller 24 may include or be in communication with a command decoder (CMD) 30. CMD 30 may be, for example, a state machine. CMD 30 may be designed as an integrated or separate device in NVM device 20, or as depicted in the embodiment of Fig. 3, it may be an internal element of micro-controller 24. It will be recognized that in some embodiments of the invention, CMD 30 may be a separate device altogether. CMD 30 may receive commands through one or more input lines, decode such received commands, and generate output signals, for example, by raising an output line of a command that is to be executed. In some embodiments, CMD 30 may decode the commands received at its input regardless of the status of NVM device 20, e.g., it may decode commands for execution while NVM device 20 is executing another command.

In an exemplary embodiment of the invention, CMD 30 may include, for example, a clock line 31 and a command input line 32. input line 32 may receive signals of the commands from an external device through communication line A, for example, via the user command interface 22. The commands entered to CMD 30 may be, for example, in 16-bit format. CMD 30 may include output lines of the commands that may be decoded by CMD 30, e.g., CMD_{program} line 34 for program command, CMD_{buffer-program} line 35 for programming to a buffer, CMD_{program-behp} line 36 for Buffer Enhanced Factory Programming command, CMDₑᵣₐₛₑ line 37 for erase command, CMD_{suspend} line 38 for suspend command, and CMDᵣₑₛᵤₘₑ line 39 for resume command.

When a legal command sequence is entered to CMD 30, the output line related to the entered command may be raised. For example, when a legal "word program" sequence is entered, a CMD_{Program} output signal 34 may be raised regardless the status of the program operation, e.g., completion or error, until the external device may attempt to write a different command sequence. When CMD_{program} output signal 34 is raised, a different embedded command that may be requested by the external device while the NVM device 20 is busy completing the "word program" command may be ignored. Additional signals that may be raised during the operation of the CMD 30 may be, for example, CMD_{buffer-program} 35, which may be raised when a command that was written to a buffer is decoded; CMD_{program-behp} 36, which may be raised when a Buffer Enhanced Factory Programming command is decoded; CMDₑᵣₐₛₑ 37 which may be raised when a legal erase command is decoded, CMD_{suspend} 38, which may be raised when a legal suspend command is decoded, and CMDᵣₑₛᵤₘₑ 39, which may be raised when a legal resume command is decoded.

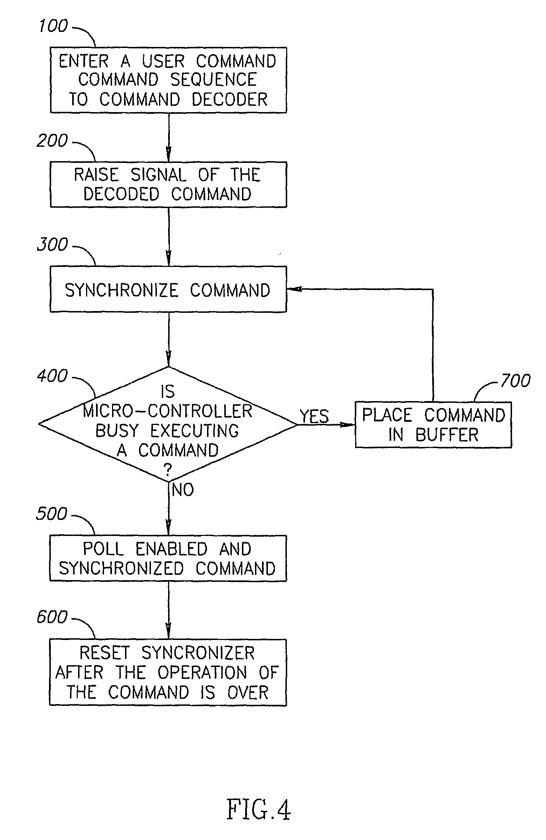

Reference is now made to Fig. 4, which is a flow chart illustration of an execution of a command controlled by micro-controller 24 in accordance with some embodiments of the present invention. In the exemplary embodiment depicted in Fig. 4, the execution of a program command is described. It will be understood that any number of other commands, such as erase, may likewise be executed with minor variations, as necessary. The execution of the program command may be initiated by entering a user command sequence of a program command to CMD 30 (block 100). After the program command sequence is decoded as described above, the signal of the decoded command may be raised (block 200), e.g., when the program command is decoded the CMD_{program} line may be raised. The signals from the CMD may be synchronized (block 300) by driving the signals to a synchronizer block as described below. Commands may be synchronized to ensure that the commands are inserted to the micro-controller when it may control their execution. After synchronizing the command, if the micro-controller is not busy executing a command, the decoded and synchronized command may be polled by the micro-controller (blocks 400 and 500). If the micro-controller is busy executing a command, decoded and synchronized command may be placed in a buffer (block 700). From the buffer, the command may be synchronized again until the micro-controller has completed its previous command execution and is available to execute the buffered command. When the micro-controller completes the operation of the polled command, the synchronizer may be reset (block 600) to enable polling of additional commands.

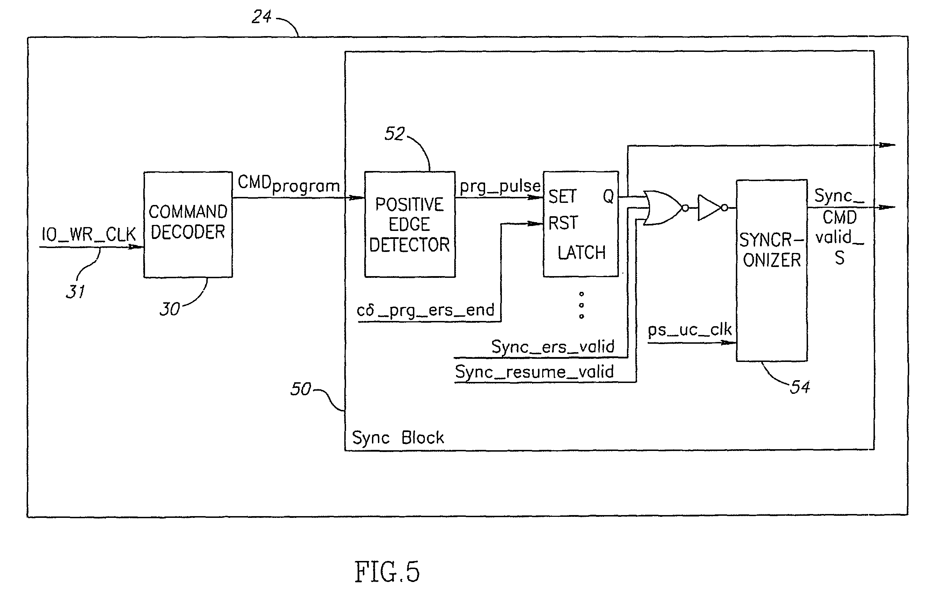

Reference is now made to Fig. 5, which is a simplified block diagram of a command synchronization block (Sync block), in accordance with an embodiment of the present invention. Sync block 50 may be designed as a separate device in NVM device 20, or as an internal element in micro-controller 24. For the sake of clarity, Sync block 50 is described as an internal element in micro-controller 24, although it will be recognized that Sync block 50 may be located as a separate device in NVM device 20. Sync block 50 may receive signals from CMD 30, and transfer signals to micro-controller 24. In an exemplary embodiment, the signals that sync block 50 may transfer may be of at least two kinds: signals that may inform that a command is valid and synchronized, and signals that may enable the micro-controller 24 to absorb the command. In the exemplary embodiment below, the synchronization of a program command is described.

In accordance with an embodiment of the present invention sync block 50 may include, for example, a positive edge detector 52, K latches for K embedded commands, and a synchronizer 54. The exemplary latch presented in Fig. 5, may be used to synchronize a program command. Each of the K latches may be, for example, an S-R latch, with two stable states, set and reset. The condition of each latch may be determined as set when a command pulse signal is transferred from positive edge detector 52 to the latch. Positive edge detector 52 may send the command pulse signal to the respective latch when a command signal is received from CMD 30. For example, when the positive edge detector receives a CMD_{program} signal, a program pulse prg_pulse may be sent to the respective latch. All K output signals from the K latches may be transferred through logic "NOR" transistors to synchronizer 54. In addition, as depicted in fig. 5 by the ps_uc_clk line, the clock of the micro-controller may also transfer signals to synchronizer 54. Accordingly, a command may be synchronized when synchronizer 54 receives a signal, for example, from the clock of the micro-controller and a signal from positive edge detector 52 through the applicable latch. An execution of an embedded operation may be performed by the micro-controller in less than 500ns after the latch is set.

In accordance with an exemplary embodiment of the present invention, when the execution of an embedded command is completed, micro-controller 24 may reset the latch to avoid a repeated execution of the same command by raising the signal of the reset line of the applicable latch (cb_prg_ers_end line depicted in fig. 4). At this stage all other K-1 latches may also be in reset mode, to prevent the execution of commands written by the external device when another command is executed. The described structure assures that each command may set one latch at a time. Therefore, when a new command is decoded and synchronized substantially immediately after a former command is executed, NVM device 20 may either execute the command or ignore it because the latch of the command is in reset mode, but the NVM device may not be in an undefined state, e.g., when the command is neither executed nor ignored.

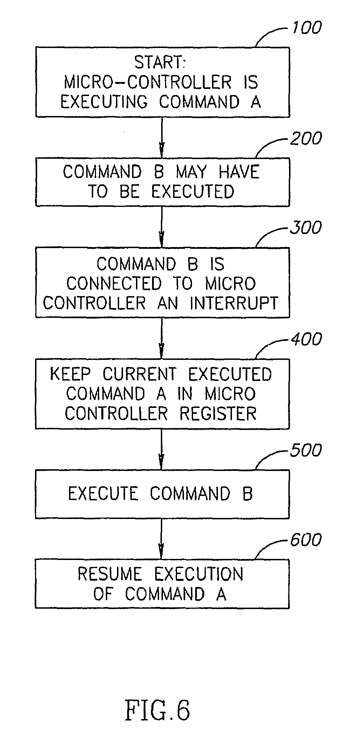

Reference is now made to Fig. 6, which is a flow chart illustration of a method to execute a command when the micro-controller is executing another command. Several commands may have to be executed by micro-controller 24 while it is executing other commands, e.g., while command A is executed (block 100), a command B may have to be executed (block 200). Trying to poll command A during the execution of the other command B may be time consuming, since in accordance with the poiiing procedure, every few microseconds micro-controller 24 may have to halt execution of commands and check for new commands. Alternatively, the several commands that may have to be executed by the micro-controller even when it is executing other commands may be connected as interrupts to micro-controller 24. An interrupt is an asynchronous event that typically suspends the currently scheduled or synchronized command and temporarily diverts the flow of control of the micro-controller through an interrupt handler routine. Interrupts may be caused by both hardware, e.g., I/O, timer, machine check, and software, e.g., supervisor, system call, or trap instruction.

There may be several interrupt channels or addresses for different purposes. For example, suspend command may be connected as an interrupt to micro-controller 24, and when a suspend command is required, the suspend command may be inserted to micro-controller 24 as an interrupt, using its interrupt channel or address. Accordingly, when command B, for example, may have to be executed, it may be connected as an interrupt to micro-controller 24 (block 300). Then, the command that may be executed by the micro-controller 24, e.g., command A, may be kept, for example, in the registers of the micro-controller 24 (block 400), when command B is connected to the micro-controller 24 as an interrupt. Consequently, command B may be executed by micro-controller 24 (block 500) without corrupting the command that was executed previously. When the execution of the command is completed, the micro-controller may resume the execution of the previous command, e.g., command A (block 600), according to the data that may be stored, in this example, in the registers of micro-controller 24. The described process of executing commands by connecting them as interrupts to the micro-controller may be implemented with substantially no hardware overhead.

In accordance with this embodiment, in some situations an executed command may have to complete its execution without being interrupted by another command, e.g., during high voltage switching. In these cases, the micro-controller may block the interrupts by raising, for example, a no-interrupts signal while the sensitive command is being executed.

The following is an example of the interrupt mechanism that may be used to force micro-controller 24 to operate a command. A suspend command may be, for example, connected to micro-controller 24 as an interrupt, and may be executed in accordance with this embodiment of the present invention. In cases that an external device enters a suspend command when other commands are executed, and interrupts are not blocked by the micro-controller, the state of the current command may be kept in the registers of micro-controller 24, and the suspend command may be executed. When the execution of the suspend command is completed, the execution of the current command may be resumed according to the data that may be stored in the registers of micro-controller 24.

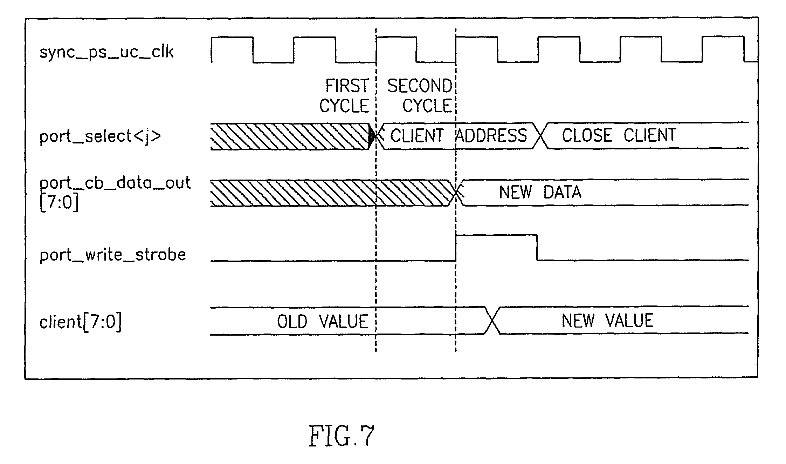

Reference is now made to Fig. 7 which is a simplified graph of a simulation of various signals involved in a data out operation of one of the periphery blocks P₁ through Pₙ (as shown in fig. 2), in accordance with an exemplary embodiment of the present invention. Communication buses C₁₋Cₙ, that were briefly depicted in Fig. 2, may connect micro-controller 24 to periphery blocks P₁ through Pₙ, respectively. Accordingly, micro-controller 24 may operate periphery blocks P₁ through Pₙ, and it may receive data from them. Each of the periphery blocks P₁ through Pₙ may have a sub block, referred hereinafter as a "client" (not shown in Fig. 2). A client may include, for example, up to 8 flip-flops, and their values may be set through signals received by communication buses C₁-Cₙ- Micro-controller 24 may send signals through communication buses C₁-Cₙ by, for example, accessing a bank of registers ("port block"), each one may be 8 bits width, within communication bus C₁-Cₙ. The port block may include, for example, 16 registers, and micro-controller 24 may access the registers with read and write commands with unique commands to each register.

Communication bus C₁-Cₙ may include various signals to operate periphery blocks P₁ through Pₙ. For example, a data out signal may be transferred to a port block, to write data to a client. Similarly, a data in signal may be transferred, for example, to a port block to sample the data that may be received from a client to communication buses C₁-Cₙ. The correct operation of NVM device 20 may be obtained when one client transfers its data every clock edge. An additional signal may be used to select a client. In accordance with this exemplary embodiment, a client may be written when its select signal is high. A global enable signal may also be transferred and when this signal is transferred every client may be written.

Referring back to Fig. 7, in order to change the data of a client, a data out operation may be applied. Accordingly, the client may be selected by turning on the select signal of the selected client, e.g., port_select <i> in Fig. 7. Additionally, the data out signal, e.g., an 8 bits signal port_cb_data_out, may be turned on, and accordingly the port block may turn on the global enable signal. In case the same client has to be written with different values sequentially, the global enable signal may remain turned on. Afterwards, the client may be released, so that the next data out is not written to more than one client. As seen in fig. 7, the data may be written to the client when a client is selected, the global enable signal is turned on and when the clock of the NVM device 20 is in a falling edge.

In accordance with an exemplary embodiment of the present invention, a type of a data control may be selected to select a client for receiving and transferring data from and to micro-controller 24 through communication bus C₁-Cₙ. The types of the data control may be defined, for example, by the three most significant bits of client select signal. Table 1 presents an exemplary configuration of the three most significant bits to define the data control.

**Table 1**

| | Bit 7 | Bit 6 | Bit 5 |
|---|---|---|---|
| Regular access | 0 | 0 | 0 |
| One shot access | 0 | 0 | 1 |
| Clear access | 0 | 1 | 0 |
| Set access | 1 | 0 | 0 |

In regular access data control mode, for example, bits 5, 6, and 7 may be reset to '0'. This mode may be used to send the data on the port block without modifying the data.

In one shot access data control mode, bit 5, for example, may be set to '1'. This mode may be used to configure the client to one clock period of the NVM device 20.

In a clear access data control mode, bit 6, for example, may be set to '1'- A clear access mode may be used when a control bit with a data value equal to '0' may be cleared, whereas a control bit with a data value equal to '1' may not change its value. For example, micro-controller may access a client through communication bus C₁-Cₙ, to clear only bit number 4 of the client. The required data in the data out signal may be, for example, 11101111B. Accordingly, first, the argument 01000001B may be written to the select signal, and then the required data, 11101111B, may be transferred via the data out signal. If more than one bit is equal to "0", all "0" bits may be cleared.

In set access data control mode, bit 7 may be set. This mode may be a mirror mode of the clear access data control mode. A set access mode may be used when a control bit with a data value equal to '1' may be set, whereas a control bit with a data value equal to '0' may not change its value. For example, micro-controller may access a client through communication bus C₁-Cₙ, to set only bit number 4 of the client. The required data in the data out signal may be, for example, 00010000B. Accordingly, first, the argument 10000001B may be written to the select signal, and then the required data, 00010000B, may be transferred via the data out signal. If more than one bit is equal to '1', all '1' bits may be cleared

In accordance with an exemplary embodiment of the present invention, micro-controller 24 may be used to add built-in self test (BIST) options to NVM device 20, with substantially no hardware overhead. A BIST is typically the ability of an NVM device to internally generate the sequence of internal tests required to verify its functionality. Typically, the memory and the logic of a new generation of a memory device are tested during the SORT phase or when the memory device is characterized. Typically, Memory testing logic testing has several components that are different from each other. Memory tests, for example, may require specialized tests such as the functional test patterns to detect for the memory array pattern sensitivity faults and data retention measurements, under worst-case refresh timings and operating temperature extremes. These several components may require additional hardware in the device to support their functionality. In accordance with this exemplary embodiment of the present invention, micro-controller 24 may be used to control BIST options, with substantially no hardware overhead. The BIST options may be written to PFROM 26, and may be executed during the SORT stage or when NVM device 20 may be in a mature state. In accordance with this embodiment, the BIST options may be changed during the development of NVM device 20, and there may be substantially no influence in its development and manufacturing time, because the change may be implemented by adapting the commands written to PFROM 26. Furthermore, in accordance with this embodiment, the BIST options may be executed after the SORT or the characterization phase of NVM device 20.

In accordance with an embodiment of the present invention, micro-controller 24 may be adapted to control the operation of NVM device 20 and of the external device, or the operation of more than one NVM devices. The operation of more than one NVM device or of the external device may be achieved by utilizing the communication line A (see fig. 2) and user command interface 22 to send signals to operate the periphery blocks of the NVM device or external device.

It will be appreciated by persons skilled in the art that the present invention is not limited by what has been particularly shown and described herein above. For example, although particular commands and operation flows have been described, it will be understood that other commands and operation flows may be employed within the bounds of the invention, and that the invention is not limited in this regard.

## Claims

1. A non-volatile memory (NVM) device comprising a micro-controller adapted to control peripheral circuitry associated with an NVM array.

2. The NVM device according to claim 1, further comprising a user command interface to receive at least one command and insert said command to said micro-controller.

3. The NVM device according to claim 1, further comprising a second NVM array configured to store at least one command to be executed by said micro-controller.

4. The NVM device according to claim 3, wherein said second NVM array is a program file read only memory (PFROM).

5. The NVM device according to claim 3, wherein said at least one command, when executed during a power-up process, configures said NVM device.

6. The NVM device according to claim 3, wherein said at least one command, when executed during a power-up process, validates that said NVM device is in a predetermined threshold voltage level.

7. The NVM device according to claim 3, wherein said at least one command, when executed during a power-up process, replaces a defected area of said NVM array with an unused area of said NVM array.

8. The NVM device according to claim 3, wherein said micro-controller is adapted to execute commands by polling said second NVM array.

9. The NVM device according to claim 1, wherein said micro-controller is adapted to receive a second command while said peripheral circuitry operate a first command, interrupt the execution of said first command, and control said peripheral circuitry to operate said second command.

10. The NVM device according to claim 2, wherein said micro-controller is adapted to receive said at least one command from an external device.

11. The NVM device according to claim 10, wherein said external device is a personal digital assistant (PDA).

12. The NVM device according to claim 10, wherein said external device is a handheld device.

13. The NVM device according to claim 10, wherein said external device is a programmable logic device (PLD).

14. The NVM device according to claim 10, wherein said external device is a memory card.

15. The NVM device according to claim 10, wherein said external device is a multimedia card.

16. The NVM device according to claim 1, wherein said micro-controller is adapted to control operation of at least a second NVM device.

17. A system comprising:
a NVM device including a NVM array adapted to store data and commands, peripheral circuitry adapted to operate said NVM array and a micro-controller adapted to control said peripheral circuitry; and
an external device to provide said at least one command to said micro-controller of said NVM device.

18. The system of claim 17, wherein said NVM device includes a user command interface to receive at least one command and provide said at least one command to said micro-controller.

19. The system of claim 18, wherein said external device is a personal digital assistant (PDA).

20. The system of claim 18, wherein said external device is a handheld device.

21. The system of claim 18, wherein said external device is a programmable logic device (PLD).

22. The system of claim 18, wherein said external device is a memory card.

23. The system of claim 18, wherein said external device is a multimedia card.

24. A method for operating a non-volatile memory (NVM) device, comprising:
providing at least one operation command to a micro-controller of said NVM device; and
applying operating signals to peripheral circuitry of said NVM device to operate a NVM array based on said at least one operation command.

25. The method of claim 24, wherein said providing at least one operating command is performed during development of said NVM device.

26. The method of claim 24, wherein said providing at least one operating command is performed during manufacturing of said NVM device.

27. The method of claim 24, wherein said providing at least one operating command is performed during production of said NVM device.

28. The method of claim 24, wherein said providing at least one operating command is performed during testing of said NVM device.

29. The method of claim 24, wherein said providing at least one operating command is performed during power-up of said NVM device.
